# EUROPEAN PATENT APPLICATION

(11) **EP 4 395 525 A2**
(43) Date of publication of application: **03.07.2024**
(21) Application number: 23185777.2
(22) Date of filing: 17.07.2023
(51) Int. Cl.: H10N 70/20, H10B 63/00

(54) **RESISTIVE MEMORY DEVICE INCLUDING VERTICAL STACK STRUCTURE, METHODS OF MANUFACTURING AND OPERATING THE SAME, AND ELECTRONIC APPARATUS INCLUDING THE RESISTIVE MEMORY DEVICE**

(30) Priority: 27.12.2022 KR 20220185903
(71) Applicant: Samsung Electronics Co., Ltd., Suwon-si, Gyeonggi-do 16677 (KR)
(72) Inventor: KIM, Seyun, Suwon-si 16678 (KR); KANG, Jooheon, Hwaseong-si 18448 (KR); Yumin, KIM, Suwon-si 16678 (KR); PARK, Garam, Suwon-si 16678 (KR); SONG, Hyunjae, Suwon-si 16678 (KR); AHN, Dongho, Hwaseong-si 18448 (KR); YANG, Seungyeul, Suwon-si 16678 (KR); WOO, Myunghun, Hwaseong-si 18448 (KR); LEE, Jinwoo, Hwaseong-si 18448 (KR); HYUN, Seungdam, Suwon-si 16678 (KR)
(74) Representative: Elkington and Fife LLP

(57) **Abstract**

Disclosed is a resistive memory device (CS) including a vertical stack of memory cells (MC), each memory cell comprising a gate electrode (140), a resistance change layer (124), a (semiconductor transistor) channel (132) between the gate electrode and the resistance change layer, an island structure (128) between and in contact with the resistance change layer and the channel, and a gate insulating layer (136) between the gate electrode and the channel. Preferably, the island structure includes SiN, GaN, or an oxide having a greater absolute value of oxide formation energy than the resistance change layer. A method of fabricating such memory cells is also disclosed.

## Description

### FIELD OF THE INVENTION

Various example embodiments relate to a memory device, and more particularly, to a memory device including a structure in which a plurality of memory cells are vertically stacked, and/or method of manufacturing and operating the same, and/or an electronic apparatus including the memory device.

### BACKGROUND OF THE INVENTION

Recently, in step with the trend of high performance and/or low power consumption of semiconductor memory devices, next-generation semiconductor memory devices, such as magnetic random access memories (MRAMs), phase change random access memories (PCRAMs), and resistive random access memories (ReRAMs) have been developed. Resistance values of materials constituting these next-generation semiconductor memory devices vary depending on one or more of current, voltage, or heat, and are maintained even when power supply is interrupted. Research has been conducted to apply these memories in the form of Vertical NAND (VNAND).

In the case of NAND flash products, which currently dominate the memory market, VNAND products, which are advantageous for increasing density, are the main products. However, VNAND products are gradually approaching a limit of allowable height in current chip packaging. Therefore, a method for increasing the scaling of a unit cell is being studied.

In the resistive VNAND using the resistive memory, the formation and removal of oxygen vacancies are expected to be made as clearly as possible during operation, and the research on this is ongoing.

### SUMMARY OF THE INVENTION

Provided are memory devices capable of increasing operational efficiency.

Alternatively or additionally, provided are memory devices capable of increasing durability.

Alternatively or additionally, provided are methods of manufacturing and operating the memory device.

Alternatively or additionally, provided are electronic apparatuses including the memory device.

Additional aspects will be set forth in part in the description which follows and, in part, will be apparent from the description, or may be learned by practice of various example embodiments.

According to some example embodiments, a memory device includes a gate electrode; a resistance change layer; a channel between the gate electrode and the resistance change layer; an island structure between the resistance change layer and the channel and in contact with the resistance change layer and the channel; and a gate insulating layer between the gate electrode and the channel.

Alternatively or additionally, according to some example embodiments, a method of manufacturing a memory device, the method includes forming a first pattern on an inner surface of the gate electrode; and forming a stack covering the first pattern on the inner surface of the gate electrode and including an island structure, wherein the island structure may be formed at a position corresponding to the first pattern, and the island structure may include either oxide or nitride.

Alternatively or additionally according to some example embodiments, an electronic apparatus includes the memory device described above.

### BRIEF DESCRIPTION OF THE DRAWINGS

The above and other aspects, features, and/or advantages of certain embodiments of the disclosure will be more apparent from the following description taken in conjunction with the accompanying drawings, in which:
FIG. 1 is a cross-sectional view illustrating a first memory device including a resistance change layer according to some example embodiments;
FIG. 2 is a cross-sectional view illustrating a case when the first memory device of FIG. 1 is rotated 90° to the left;
FIG. 3 is a cross-sectional view illustrating a second memory device including a resistance change layer according to some example embodiments;
FIG. 4 is a cross-sectional view illustrating a third memory device including a resistance change layer according to some example embodiments;
FIG. 5 is a plan view taken along line 5-5' of FIG. 4;
FIG. 6 is a plan view illustrating a case when the plane of the gate electrode in FIG. 5 is a quadrangle;
FIG. 7 is a cross-sectional view illustrating a memory device including a cell string using the third memory device of FIG. 4 as a unit memory cell;
FIG. 8 is a perspective view showing a schematic structure of a cell string of the memory device of FIG. 7;
FIG. 9 is a cross-sectional view illustrating a fourth memory device according to some example embodiments;
FIG. 10 is an equivalent circuit diagram of the memory device of FIG. 9;
FIGS. 11 to 13 are cross-sectional views illustrating write, read, and erase operations of the memory device of FIG. 1;
FIG. 14 is a graph showing a current-voltage relationship, calculated on a simulation using TCAD, according to an operation of a memory device according to some example embodiments;
FIGS. 15 to 27 are diagrams illustrating a method of manufacturing a memory device step by step according to some example embodiments;
FIG. 28 is a scanning electron microscope (SEM) photograph showing the result of an experiment conducted to confirm that an island structure or an island corresponding to a plurality of dots is formed in a memory device according to some example embodiments;
FIG. 29 is a block diagram of a memory system according to some example embodiments; and
FIG. 30 is a block diagram showing a neuromorphic device and an external device connected thereto according to some example embodiments.

### DETAILED DESCRIPTION

Reference will now be made in detail to various embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, memory devices including a vertical stack structure according to embodiments, manufacturing and operating methods thereof, and electronic apparatuses including the memory device will be described in detail with reference to the accompanying drawings.

Various embodiments may be capable of various modifications and may be embodied in many different forms. In the drawings, like reference numerals refer to like elements throughout, and sizes of elements in the drawings may be exaggerated for clarity and convenience of explanation.

When a position of an element is described using the expression "above" or "on", the position of the element may include not only the element being "immediately on/under/left/right in a contact manner" but also being "on/under/left/right in a noncontact manner".

Although the terms "first", "second", etc. may be used herein to describe various elements, these terms are only used to distinguish one element from another. These terms are not intended to limit the difference in material or structure of the elements.

Singular forms are intended to include the plural forms as well unless the context clearly indicates otherwise. Also, when a part "comprises" or "includes" an element in the specification, unless otherwise defined, it is not excluding other elements but may further include other elements.

Also, in the specification, the terms "units" or "...modules" denote units or modules that process at least one function or operation, and may be realized by hardware, software, or a combination of hardware and software.

In the specification, the term "above" and similar directional terms may be applied to both singular and plural.

With respect to operations that constitute a method, the operations may be performed in any appropriate sequence unless the sequence of operations is clearly described. In addition, the use of any and all examples, or exemplary language (e.g., "such as") provided herein, is intended merely to better illuminate the disclosure and does not pose a limitation on the scope of the disclosure unless otherwise claimed.

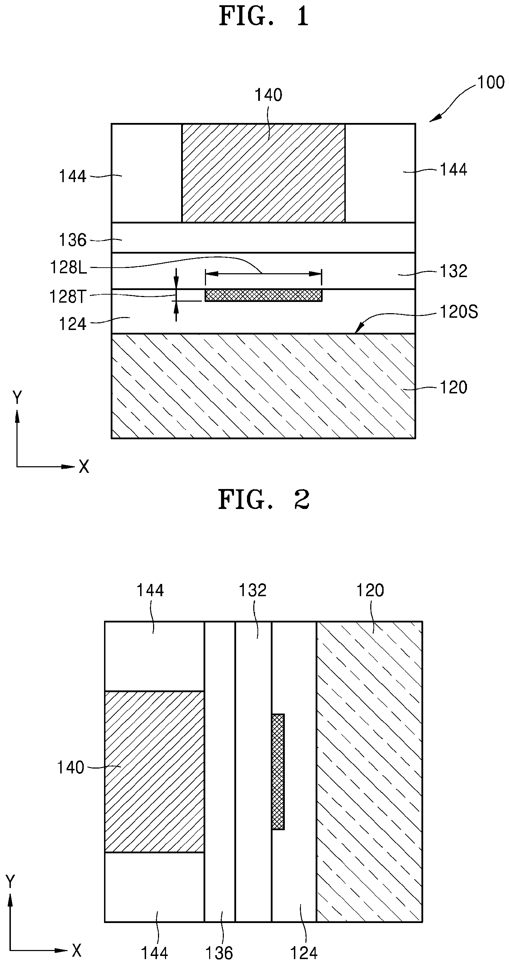

FIG. 1 shows a first memory device 100 including a resistance change layer according to some example embodiments. In one example, the first memory device 100 may be a unit memory cell that is a minimum unit device for writing data.

Referring to FIG. 1, the first memory device 100 includes a base 120, a resistance change layer 124, a channel 132, a gate insulating layer 136, and a gate electrode 140, which are sequentially stacked in a first direction (e.g., a Y-axis direction). The base 120 may also be expressed as or referred to as a base layer 120. The channel 132 may also be expressed as or referred to as a channel layer 132. The gate electrode 140 may also be expressed as or referred to as a gate electrode layer 140. In one example, the base 120 may include an insulating layer. In some example embodiments, the insulating layer may be an oxide layer or include an oxide layer. For example, in some example embodiments , the oxide layer may be a silicon oxide (e.g., SiO₂) layer or include a silicon oxide layer. The resistance change layer 124 may be provided on one surface 120S of the base 120 and directly contact the one surface 120S, but is not limited thereto. The one surface 120S may be perpendicular to the first direction and may be parallel to a second direction (e.g., an X-axis direction) perpendicular to the first direction. The one surface 120S may be parallel to a plane (an X-Z plane) defined by the X axis and the Z axis, but is not limited thereto.

In FIG. 1, the one surface 120S of the base 120 may be an upper surface, but may also be interpreted as a lower surface, a side surface, or an inclined surface depending on viewpoints. The same interpretation may be applied to all sides of members mentioned in the following description. In the first direction, a thickness of the base 120 and a thickness of the resistance change layer 124 may be the same or different from each other. In some examples, the resistance change layer 124 may include a variable resistance material. The variable resistance material may be one or more of Rb₂O, TiO₂, BaO, ZrO₂, CaO, HfO₂, SrO, Sc₂O₃, MgO, Li₂O, Al₂O₃, SiO₂, BeO, Sc₂O₃, Nb₂O₅, NiO, Ta₂O₅, WO₃, V₂O₅, La₂O₃, Gd₂O₃, CuO, MoOs, Cr₂O₃, and MnO₂.

The resistance change layer 124 may have a relatively high resistance state (e.g., a reset state) or a relatively low resistance state (e.g., a set state) as compared with a reference resistance or a set resistance, and the resistance of the resistance change layer 124 may be based on a first operating voltage applied to the first memory device 100.

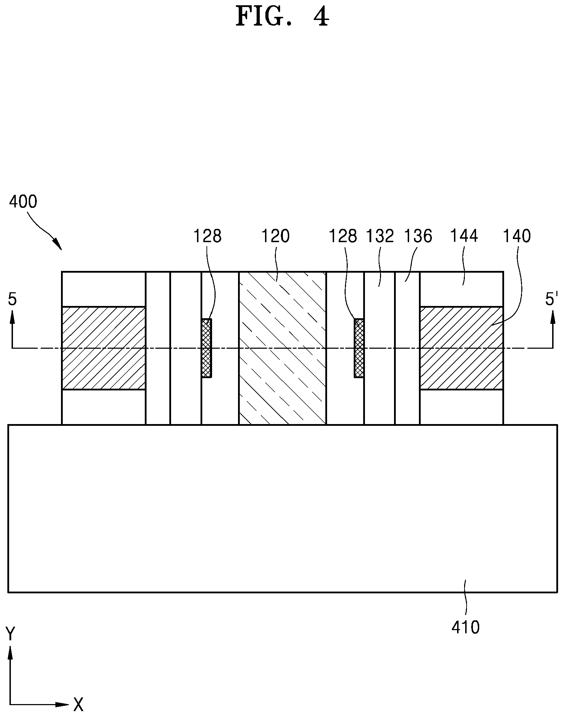

The first operating voltage may include or be based on one or more of a write voltage, a read voltage, or an erase voltage. In some examples, an island structure 128 (see, FIG. 4) may be provided between the resistance change layer 124 and the channel 132. The island structure 128 belongs only to the first memory device 100 and may be located in a region where oxygen vacancies of the resistance change layer 124 are formed during operation of the first memory device 100. For example, the island structure 128 may be located only between the gate electrode 140 and the region where the oxygen vacancy is formed in the resistance change layer 124, is not shared with other adjacent memory cells, and does not extend to other adjacent memory cell regions. Alternatively or additionally, a voltage may not be applied, e.g. may not be directly applied to the island structure 128. The island structure 128 may be variously expressed as or referred to as an isolated layer, an isolated structure, an independent structure, an island, an island layer, and the like. In some examples, the island structure 128 may be provided in a form buried in the resistance change layer 124. For example, the resistance change layer 124 may have a recess corresponding to a first thickness 128T of the island structure 128 on a surface facing the channel 132, and the island structure 128 may be provided to completely fill the recess. Alternatively or additionally, the island structure 128 may be viewed as being provided (formed) to protrude from the channel 132 to the resistance change layer 124.

As a result, the island structure 128 is in a form surrounded by the channel 132 and the resistance change layer 124. The island structure 128 may be completely surrounded by the channel 132 and the resistance change layer 124.

In some examples, the island structure 128 may have the first thickness 128T or a first height in a direction perpendicular to the one surface 120S of the base 120, and may have a first length 128L in a second direction parallel to the one surface 120S. In some examples, the first thickness 128T may be in a range from about 0.1 nm to about 10 nm, for example, in a range from about 1 nm to about 2 nm. In some examples, the first length 128L may be in a range from about 0.1 nm to about 30 nm, for example, in a range from about 1 nm to about 5 nm. In some examples, the first length 128L of the island structure 128 may be less than or equal to a length (or width) of the gate electrode 140 in the second direction (e.g., the X-axis direction).

In some examples, a cross-sectional area of the island structure 128 may be less than a cross-sectional area of the gate electrode 140. In some examples, these cross-sectional areas may be a cross-sectional areas cut in a direction perpendicular to the base 120 (a Y-axis direction, in the case of FIG. 2, a direction parallel to the X-axis), but is not limited to this direction.

In some examples, the island structure 128 may be or include a nitride layer and/or an oxide layer. The island structure 128 may be or may include a layer in which oxygen vacancies are not formed or oxygen vacancies are less likely to be formed than the resistance change layer 124. In some examples, the island structure 128 may be or may include an oxide layer in which an absolute value of a negative (-) value of oxide formation energy is greater than that of the resistance change layer 124. As the absolute value of the minus value of the oxide formation energy increases, oxygen vacancy formation may become more difficult. In some examples, the island structure 128 may be or include silicon nitride (e.g., SiN), gallium nitride (e.g., GaN), aluminum nitride (AIN), or boron nitride (BN), but is not limited thereto. In some examples, the island structure 128 may be or include a metal oxide layer. In some examples, the metal oxide may include at least one from the group consisting of (or including) Rb, Ti, Ba, Zr, Ca, Hf, Sr, Sc, Mg, Al, Si, Be, Nb, Ni, Ta, W, V, La, Gd, Cu, Mo, Cr, and Mn, but is not limited thereto. For example, the island structure 128 may be or include a binary metal oxide layer including one metal element or may include the metal oxide layer, and/or may be or include a ternary or higher metal oxide layer including two or more different metal elements or may include the metal oxide layer.

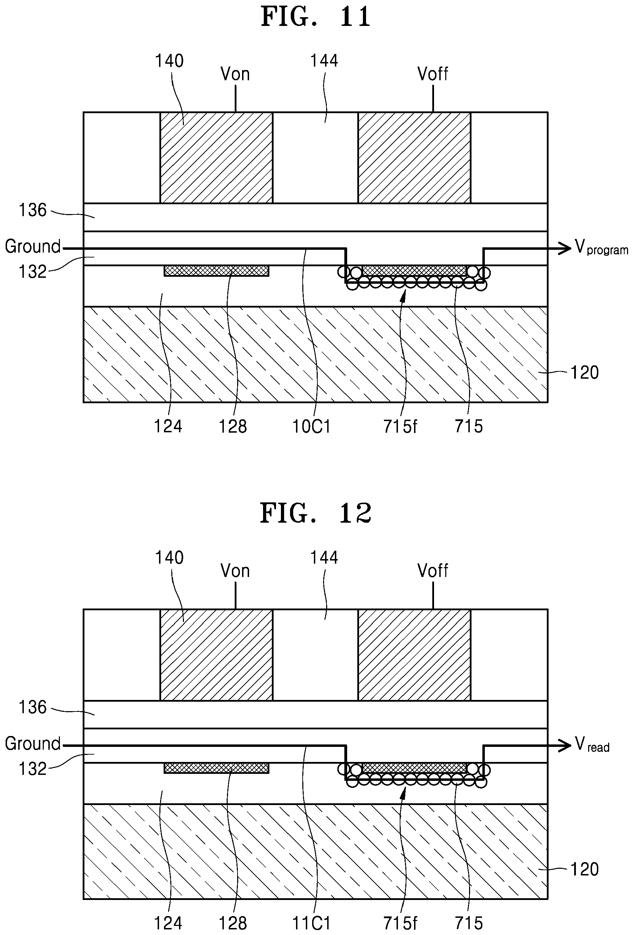

The channel 132 may be provided on the resistance change layer 124 to completely cover the island structure 128. The channel 132 may be provided to contact or directly contact a surface (e.g., an upper surface) of the island structure 128 that is not buried in the resistance change layer 124. In some examples, the entire upper surface of the island structure 128 may not be buried in the resistance change layer 124, and the channel 132 may directly contact the entire upper surface of the island structure 128. Accordingly, when a first operating voltage, for example, a write voltage, is applied to the first memory device 100, as illustrated in FIG. 11, oxygen vacancies 715 may be formed on a side surface of and bottom surface of the island structure 128 in the resistance change layer 124. As described above, because the absolute value of the minus value of the oxide formation energy of the island structure 128 is greater than that of the resistance change layer 124, oxygen vacancies may not be formed or may be less likely to form in the island structure 128 by the first operating voltage. In some examples, the channel 132 may be or include a single-crystal or poly-crystal silicon layer and may or may not be doped, but the material or state of the material may not be limited thereto.

The gate electrode 140 may be present on the gate insulating layer 136 and may be provided to cover the entire island structure 128 on the island structure 128 or at a position facing the island structure 128. In some examples, the gate insulating layer 136 may be or include an oxide layer. An insulating layer 144 is provided on both sides of the gate electrode 140 on the gate insulating layer 136. The both side surfaces of the gate electrode 140 may be covered with the insulating layer 44 and may directly contact the insulating layer 144. The material of the insulating layer 144 may be silicon oxide (e.g., SiO₂) and/or aluminum oxide (e.g., Al₂O₃).

FIG. 2 shows a case when the first memory device 100 of FIG. 1 is rotated 90° to the left.

In the case of FIG. 2, the base 120, the resistance change layer 124, the channel 132, the gate insulating layer 136, and the gate electrode 140 of the first memory device 100 are stacked in the horizontal direction, for example, in a direction opposite to the second direction (a X-axis direction). In FIG. 2, the resistance change layer 124 is disposed parallel to the Y-axis (the first direction) and perpendicular to the X-axis (the second direction). In the case of FIG. 1, if the resistance change layer 124 is formed horizontally, in the case of FIG. 2, it may be said that the resistance change layer 124 is formed vertically.

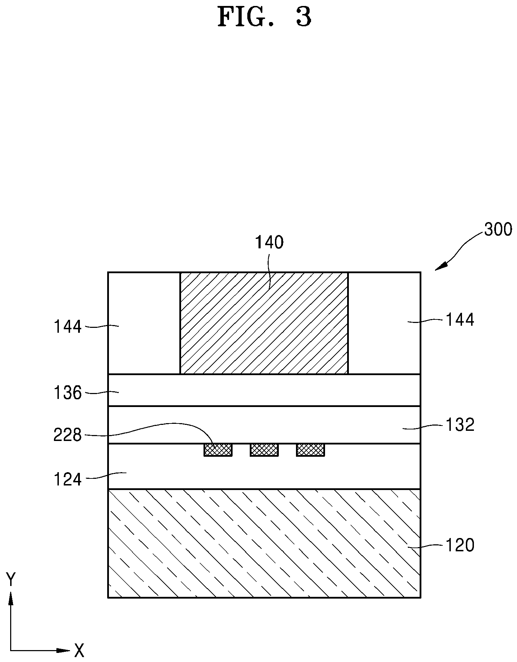

FIG. 3 shows a second memory element 300 according to some example embodiments. Only parts different from the first memory device 100 of FIG. 1 will be described. The same reference numerals as those mentioned in the description of the first memory device 100 denote the same members.

Referring to FIG. 3, the second memory device 300 includes a plurality of small structures or smaller disconnected features in the shape of dots 228 between the resistance change layer 124 and the channel 132. The entirety of the plurality of dots 228 may be referred to as a second island structure, or as an archipelago structure that has a plurality of small islands. The plurality of small islands, or the plurality of dots 228 may be spaced apart from each other. The location and/or the region of the plurality of dots 228 may be the same as the location and/or the region of the island structure 128 of the first memory device 100 of FIG. 1. Therefore, the arrangement relationship between the plurality of dots 228 and the other layers 124, 132, and 140 may be the same as that between the island structure 128 and the other layers 124, 132, and 140 in the first memory device 100. The plurality of dots 228 may be equivalent to the island structure 128 being divided into a plurality of pieces at the location where the island structure 128 of the first memory device 100 of FIG. 1 is formed. Therefore, a material of the plurality of dots 228 may be the same as that of the island structure 128. A mutual interval of the plurality of dots 228 may be the same as or different from each other. In some examples, the plurality of dots 228 may be provided to have an interval in which at least one oxygen vacancy may be formed between the plurality of dots 228. In some examples, a thickness (height) of each of the plurality of dots 228 may be the same or different from each other.

In some examples, as the first memory device 100 of FIG. 1 may be rotated by 90° as shown in FIG. 2, the second memory device 300 may also be rotated by 90°.

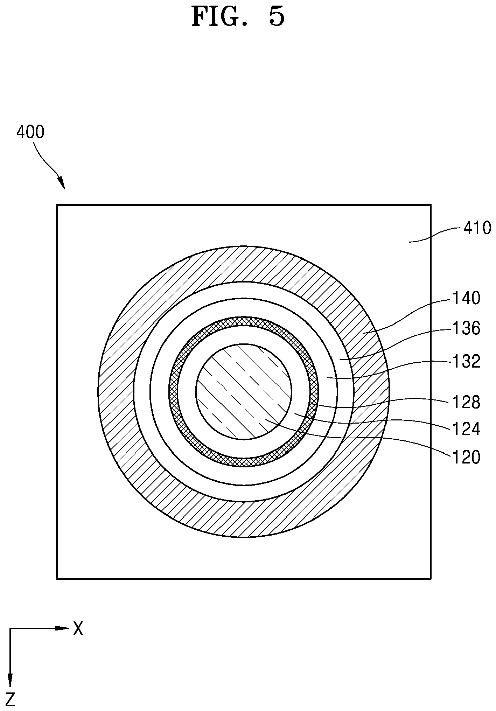

FIG. 4 shows a third memory device 400 according to some example embodiments. FIG. 5 shows a plane taken along line 5-5' of FIG. 4.

Because FIG. 4 is a cross-sectional view, the third memory device 400 appears as if the two first memory devices 100 of FIG. 2 are arranged symmetrically on the substrate 410.

Referring to FIG. 4 and FIG. 5 which is a plan view, the third memory device 400 includes the resistance change layer 124, the island structure 128, the channel 132, and the gate insulating layer 136, and the gate electrode 140 concentrically disposed around the base 120. In the third memory device 400, the resistance change layer 124, the island structure 128, the channel 132, the gate insulating layer 136, and the gate electrode 140 are sequentially stacked on a side surface of the base 120 in a direction perpendicular to the side surface of the base 120, that is, in the horizontal direction. The resistance change layer 124 may be provided to surround, e.g. to completely surround the base 120 with a constant thickness or a substantially constant thickness, and to contact the side surface of the base 120. The island structure 128 may be provided to completely surround the base 120 and the resistance change layer 124 with a constant or substantially constant thickness, and to directly contact a corresponding (facing) surface of the resistance change layer 124. In some examples, the island structure 128 may be replaced with a plurality of dots 228 of the second memory device 300 of FIG. 3. The channel 132 may be provided to completely surround the base 120, the resistance change layer 124, and island structure 128 with a constant or substantially constant thickness, and to contact a side surface of the resistance change layer 124 around island structure 128 and a side surface of the island structure 128. The gate insulating layer 136 may be provided to completely surround the base 120, the resistance change layer 124, the island structure 128, and the channel 132 with a constant or substantially constant thickness, and to contact a side surface of the channel 132. The gate electrode 140 may be provided to completely surround the base 120, the resistance change layer 124, the island structure 128, the channel 132, and the gate insulating layer 136 with a constant or substantially constant thickness, and to contact a side surface of the gate insulating layer 136.

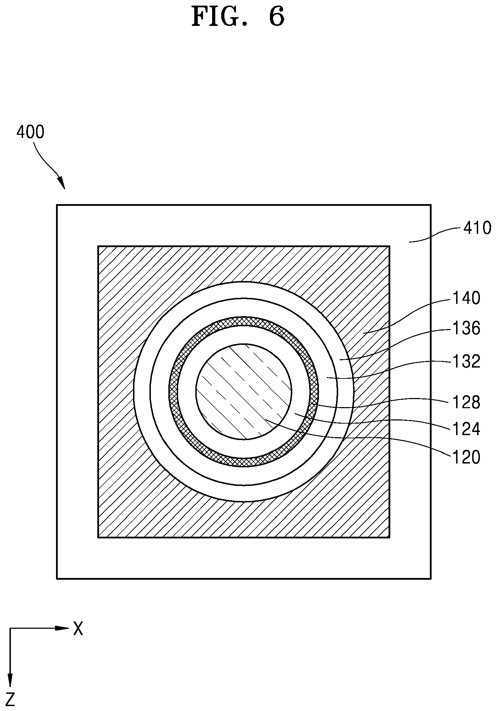

In FIG. 5, although the planar shape of the third memory device 400 is illustrated as a circular shape, the planar shape may be non-circular (e.g., elliptical, polygonal such as hexagonal or quadrilateral such as square-shaped, etc.). For example, as shown in FIG. 6, the planar shape of the gate electrode 140 may be a quadrilateral, such as a square. In FIG. 6, shapes of the base 120, the resistance change layer 124, the island structure 128, the channel 132, and the gate insulating layer 136 may be the same as those of FIG. 5. FIG. 6 shows a plane taken along line 5-5' of FIG. 4.

The third memory device 400 shown in FIGS. 4 to 6 may correspond to a unit memory cell of a resistive VNAND having a vertical resistance change layer. Therefore, a VNAND having a vertical resistance change layer may be formed with the plurality of third memory devices 400.

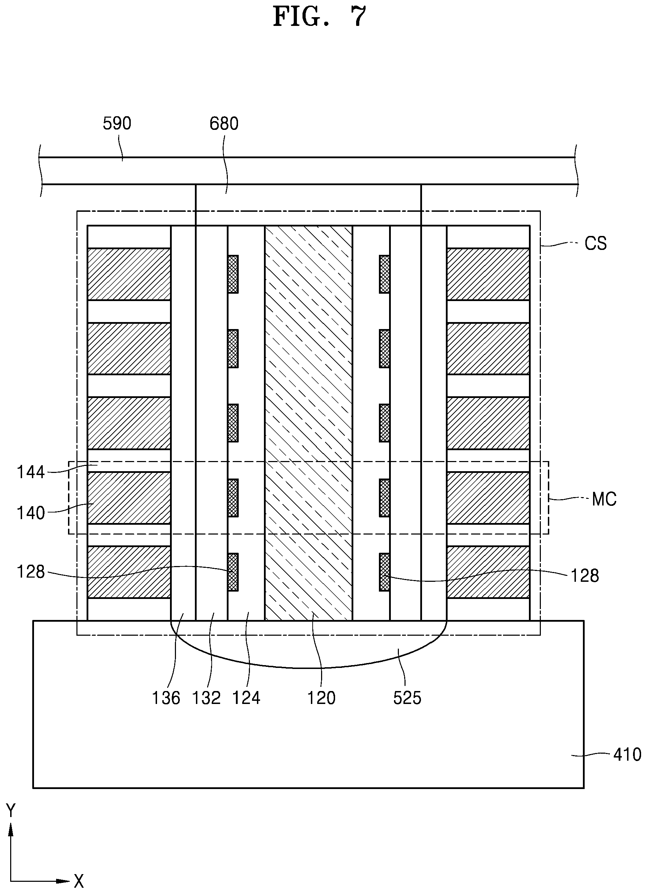

FIG. 7 shows an example of the resistive VNAND in which five unit memory cells MC are sequentially stacked on one surface (e.g., an X-Z plane) of the substrate 410 in a direction perpendicular to the one surface (e.g., a Y-axis direction). The unit memory cell MC may be or may include or be included in a remaining portion of the third memory device 400 except for the substrate 410. Accordingly, the unit memory cell MC may be substantially the same as the third memory device 400. The number of unit memory cells MC sequentially stacked in the vertical direction may be N. The plurality of unit memory cells MC sequentially stacked in the vertical direction on the substrate 410 may form a cell string CS in a resistive VNAND.

A gate electrode 140 of each of the vertically stacked memory cells MC in the cell string CS may be electrically separated by an insulating layer 144. Also, in the cell string CS, the channel 132 of each memory cell MC and the resistance change layer 124 are connected to each other in a vertical direction.

An inner region of the gate electrode 140 at the bottom of the cell string CS is in contact with an impurity doped region 525 of the substrate 410, and an inner region of the gate insulating layer 136 at the top of the cell string CS is connected to a bit line 590 through a drain region (layer) 680. The impurity doped region 525 may be a common source region shared by other cell strings. A lower end of the cell string CS may be regarded as a bottom of the cell string CS. In the inner region of the gate electrode 140 at the lower end of the cell string CS, the lower ends (bottom surfaces) of the base 120, the resistance change layer 124, and the channel 132 may directly contact the impurity doped region 525. A lower end (bottom) of the gate insulating layer 136 may or may not contact the impurity doped region 525. The drain region 680 may be provided to cover an inner region of the gate insulating layer 136 at an upper end of the cell string CS and to contact the inner region of the gate insulating layer 136. The bit line 590 is positioned on the drain region 680 and may directly contact the drain region 680. The drain region 680 may be provided between the bit line 590 and the cell string CS.

An upper end of the cell string CS may be regarded as an upper surface of the cell string CS. The inner region of the gate insulating layer 136 at the upper end of the cell string CS may include the upper ends (upper surfaces) of the base 120, the resistance change layer 124, and the channel 132.

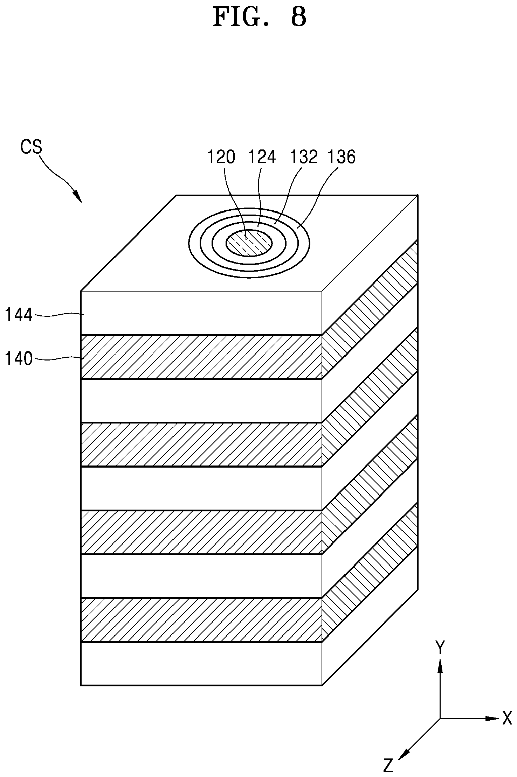

FIG. 8 is a three-dimensional view of the cell string CS of FIG. 7.

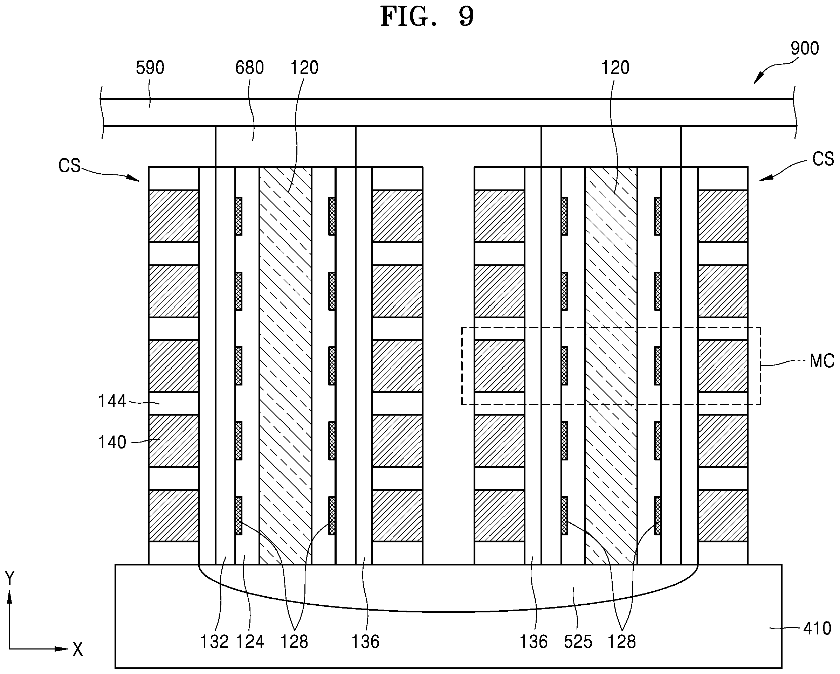

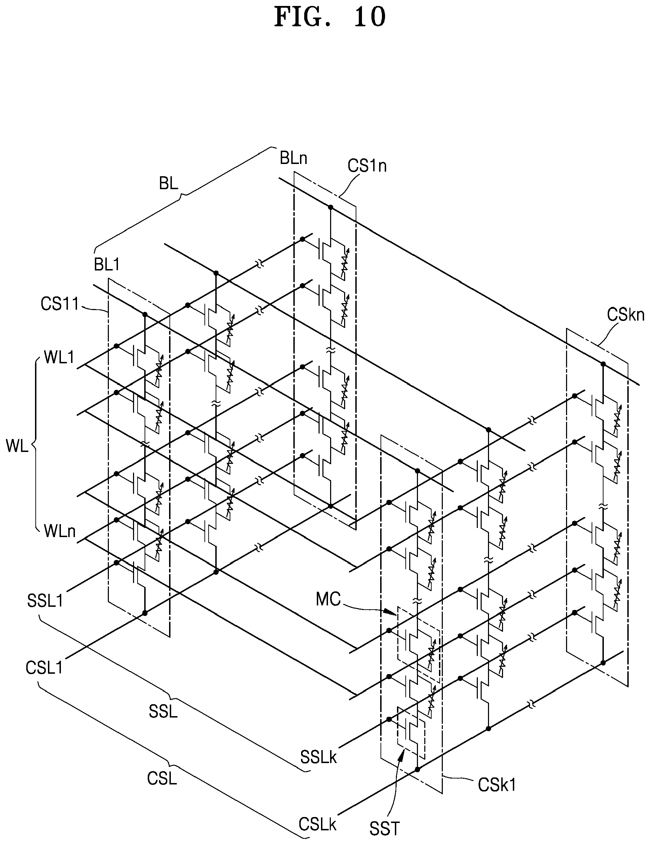

The cell string CS illustrated in FIG. 7 may be provided in plural on the substrate 410, and, as an example of the plurality of cell strings CS, FIG. 9 schematically shows a resistive VNAND 900 in which two cell strings CS are provided on the substrate 410. FIG. 10 is an equivalent circuit diagram of the resistive VNAND 900 of FIG. 9.

With reference to FIGS. 9 and 10 together, a detailed configuration of the resistive VNAND 900 will be described.

A plurality of cell strings CS are provided on the substrate 410.

The substrate 410 may include a silicon material doped with a first type impurity. For example, the substrate 410 may include a silicon material doped with a p-type impurity. For example, substrate 410 may be a p-type well (e.g., a pocket p-well). In the following, it is assumed that the substrate 410 is p-type silicon. However, the substrate 410 is not limited to p-type silicon.

An impurity doped region 525 as a source region is provided on the substrate 410. The impurity doped region 525 may be n-type different from that of the substrate 410. Hereinafter, it is assumed that the impurity doped region 525 is n-type, e.g. is doped with impurities such as arsenic and/or phosphorus. However, the impurity doped region 525 is not limited to n-type. The impurity doped region 525 may be connected to a common source line CSL.

As shown in the equivalent circuit diagram of FIG. 10, k*n cell strings CS may be provided and arranged in a matrix form. The cell string CS may be named CSij(1≤i≤k, 1≤j≤n) according to each row and column position. Each cell string CSij is connected to a bit line BL, a string-select line SSL, a word line WL, and a common source line CSL.

Each cell string CSij includes memory cells MC and a string-select transistor SST. The memory cells MC and the string-select transistor SST of each cell string CSij may be stacked in a height direction.

Rows of the plurality of cell strings CS are respectively connected to different string selection lines SSL1 to SSLk. For example, the string-select transistors SSTs of the cell strings CS11 to CS1n are commonly connected to the string-select line SSL1. The string-select transistors SST of the cell strings CSk1 to CSkn are commonly connected to the string-select line SSLk.

Columns of the plurality of cell strings CS are respectively connected to different bit lines BL1 to BLn. For example, the memory cells of the cell strings CS11 to CSk1 and the string-select transistors SST may be connected in common to the bit line BL1, and the memory cell MC of the cell strings CS1n to CSkn and the string-select transistors SST may be commonly connected to the bit line BLn.

Rows of the plurality of cell strings CS may be respectively connected to different common source lines CSL1 to CSLk. For example, the string-select transistors SST of the cell strings CS11 to CS1n may be connected in common to the common source line CSL1, and the string-select transistors SST of the cell strings CSk1 to CSkn may be commonly connected to the common source line CSLk.

Gate electrodes of the memory cells MC positioned at the same height from the substrate 410 or the string-select transistors SST are commonly connected to one word line WL. Gate electrodes of the memory cells MC positioned at different heights may be connected to different word lines WL1 to WLm, respectively.

The circuit structure shown is an example. For example, the number of rows of the cell strings CS may increase or decrease. As the number of rows of the cell strings CS changes, the number of string selection lines connected to the rows of the cell strings CS and the number of cell strings CS connected to one bit line may also change. As the number of rows of the cell strings CS changes, the number of common source lines connected to the rows of the cell strings CS may also change.

The number of columns of the cell strings CS may also increase or decrease. As the number of columns of the cell string CS changes, the number of bit lines connected to the columns of the cell strings CS and the number of cell strings CS connected to one string selection line may also change.

The height of the cell string CS may also be increased or decreased. For example, the number of memory cells MC stacked on each cell string CS may increase or decrease. As the number of memory cells MC stacked on each cell string CS changes, the number of word lines WL may also change. For example, the number of string-select transistors provided in each of the cell strings CS may be increased. As the number of string-select transistors provided in each of the cell strings CS is changed, the number of string-select lines or common source lines may also be changed. If the number of string-select transistors increases, the string-select transistors may be stacked in the same form as the memory cells MC.

Illustratively, writing and reading may be performed in units of rows of cell strings CS. The cell strings CS may be selected in units of one row by the common source line CSL, and the cell strings CS may be selected in units of one row by the string selection lines SSL. Also, a voltage may be applied to the common source lines CSL as a unit of at least two common source lines. A voltage may be applied to all of the common source lines CSL as one unit.

In the selected row of the cell strings CS, writing and reading may be performed in units of pages. A page may be one row of memory cells connected to one word line WL. In a selected row of the cell strings CS, the memory cells may be selected in units of pages by word lines WL.

As shown in FIGS. 7 to 9, the cell string CS may have a shape in which a plurality of gate electrodes 140 and a plurality of insulating layers 144 alternately surround a first structure including a base 120, a resistance change layer 124, an island structure 128, a channel 132, and a gate insulating layer 136. The insulating layer 144 may be a separation layer preventing or reducing an amount of mutual contact of the gate electrodes 140 between the vertically stacked gate electrodes 140.

In FIG. 8, the cell string CS is shown in the shape of a quadrangular pillar, but this is an example and not limited thereto. The cell string CS may be formed, for example, in a cylindrical shape or in a conical shape (e.g. a tapered shape).

The shape of the first structure including the base 120, the resistance change layer 124, the island structure 128, the channel 132, and the gate insulating layer 136 will be described.

For example, referring to FIGS. 7 and 9, the base 120 has a cylindrical shape in which a length direction is the Y-axis direction. The resistance change layer 124, the island structure 128, the channel 132, and the gate insulating layer 136 are sequentially stacked on a cylindrical surface of the base 120 in a radial direction.

In some examples, the channel 132 may include a semiconductor material doped with a first type. The channel 132 may include a silicon material, such as but not limited to polysilicon and/or single-crystal silicon, doped with the same type as the substrate 410. For example, when the substrate 410 includes a p-type doped silicon material, the channel 132 may also include a p-type doped silicon material. Alternatively, the channel 132 may include a material, such as Ge, IGZO, or GaAs. In some examples, channel 132 may include polysilicon.

The material of the island structure 128 is the same as the description given with reference to FIG. 1. In some examples, the island structure 128 may be replaced with the plurality of dot layers 228 of FIG. 3.

The gate insulating layer 136 surrounds a surface of the channel 132 to a predetermined thickness. The gate insulating layer 136 may include various insulating materials such as one or more of silicon oxide, silicon nitride, or silicon oxynitride.

The plurality of gate electrodes 140 and the plurality of insulating layers 144 surround an outer surface of the first structure. For example, the plurality of gate electrodes 140 and the plurality of insulating layers 144 may be provided on the outer surface of the gate insulating layer 136 and disposed to surround the outer surface of the gate insulating layer 136. The plurality of insulating layers 144 may separate the plurality of gate electrodes 140, and the plurality of gate electrodes 140 and the plurality of insulating layers 144 may be alternately and repeatedly stacked in a direction perpendicular to the substrate 410 (Y-axis direction).

The gate electrode 140 may include a metal material and/or a highly doped silicon material. Each gate electrode 140 is connected to one of the word line WL and the string-select line SSL. The insulating layer 144 may include various insulating materials, for example, silicon oxide and/or silicon nitride, but is not limited thereto.

The manufacturing process of the cell string CS described above may proceed in the order from an external structure to an internal structure. For example, a structure in which the gate electrode 140 and the insulating layer 144 having a shape of a cylinder shell with the same outer diameter and inner diameter are alternately stacked is first formed, and the gate insulating layer 136, the channel 132, the island structure 128, and the resistance change layer 124 are sequentially deposited on an inner surface of the structure. Deposition of the material layers will be described later in the description of the manufacturing method.

One end of the channel 132 and the resistance change layer 124 may contact the impurity doped region 525, that is, the common source region. The island structure 128 is spaced apart from the impurity doped region 525. The drain region 680 may be provided at the other end of the channel 132 and the resistance change layer 124. The island structure 128 is separated from the drain region 680. The drain region 680 may include a silicon material doped with a second type. For example, the drain region 680 may include a silicon material doped with an n-type impurity. The bit line 590 may be provided on the drain region 680. The drain region 680 and the bit line 590 may be directly connected or connected through contact plugs.

Each gate electrode 140 and regions of the gate insulating layer 136, the channel 132, the island structure 128, and the resistance change layer 124 facing each gate electrode 140 may constitute a memory cell MC. For example, the memory cell MC has a circuit structure in which a variable resistance by the resistance change layer 124 and the island structure 128 is connected in parallel to a transistor including the gate electrode 140, the gate insulating layer 136, and the channel 132. The parallel connection structures are continuously arranged in the vertical direction (Y-axis direction) to constitute the cell string CS. Also, as shown in the equivalent circuit diagram of FIG. 10, the common source line CSL and the bit line BL may be connected to both ends of the cell string CS. When an operating voltage is applied to the common source line CSL and the bit line BL, various operations such as program (write), read, and erase (erasure) operations may be performed on the plurality of memory cells MC.

For example, when a memory cell MC to be written is selected, a gate voltage value of the corresponding memory cell is adjusted so that a channel is not formed in the selected memory cell, e.g., the channel is turned off. The gate voltage values of the unselected memory cells are adjusted so that the channels of the unselected memory cells are turned on. Accordingly, a current path by the voltage applied to the common source line CSL and the bit line BL passes through the region of the resistance change layer 124 of the selected memory cell MC, and at this time, a low resistance state or a high resistance state may be created by setting the applied voltage as a value of Vset or Vreset, and desired 1 or 0 information may be written to the selected memory cell MC.

In a read operation, similarly to the above, a read for a selected memory cell may be performed. That is, after a gate voltage applied to each gate electrode 140 is adjusted so that the selected memory cell MC is a channel-off state and the non-selected memory cells are a channel-on state, the state (1 or 0) of the memory cell may be confirmed by measuring a current flowing in the corresponding memory cell MC by an applied voltage V_{read} between the common source line CSL and the bit line BL.

In a VNAND structure, there is a limit in increasing the number of gate electrodes 140 included in the cell string CS, due to a packaging limit according to a height of the cell string CS. In particular, there is a limit to reducing a distance between adjacent gate electrodes 140 due to interference between adjacent memory cells. Accordingly, a memory capacity may be at least partially limited by a limit value capable of reducing the sum of vertical lengths of the gate electrode 140 and the insulating layer 144 adjacent in the vertical direction (Y-axis direction).

Next, the operation of a unit memory cell of the illustrated resistive VNAND will be described in more detail.

FIGS. 11 to 13 show write, read, and erase operations of the first memory device 100 shown in FIGS. 1 and 2. The operations illustrated in FIGS. 11 to 13 may be equally applied to the second and third memory devices 300 and 400 of FIGS. 3 and 4.

Although two memory cells are shown as an example in the operations illustrated in FIGS. 11 to 13, the operation method illustrated in FIGS. 11 to 13 may be equally applied to the operation of a cell string including a plurality of memory cells.

In FIGS. 11 to 13, a memory cell on the left is regarded as a memory cell not selected as a write cell, and a memory cell on the right is regarded as a memory cell selected as a write cell.

FIG. 11 shows a data write (record) operation.

Referring to FIG. 11, a gate voltage Von for channel-on is applied to the gate electrode 140 on the left, and a gate voltage Voff for channel-off is applied to the gate electrode 140 on the right. When a write voltage V_{program} is applied to both ends of the channel 132, a current 10C1 flows along the channel 132 in the memory cell in the channel-on state (left), but no current flows along the channel 132 in the memory cell in the channel-off state (right). In this case, a strong voltage is applied to both end of a region of the channel 132 where a current does not flow, and oxygen vacancies 715 are formed around the island structure 128 of the resistance change layer 124 under the influence of the electric field caused by the strong voltage. An oxygen vacancy filament 715f may be formed along a surface of the island structure 128 by the oxygen vacancies 715 formed in this way. Accordingly, a current 10C1 flows through the oxygen vacancy filament 715f in the selected memory cell. For example, in a write operation, the oxygen vacancy filament 715f is formed in the resistance change layer 124 of the selected memory cell, and as a result, the resistance of the resistance change layer 124 of the selected memory cell is less than a reference resistance or set resistance of a memory cell. The reference resistance or set resistance may be a reference resistance for determining data written in a memory cell. For example, when the resistance of the resistance change layer 124 of the selected memory cell is greater than the reference resistance, it may be determined that the selected memory cell is in a high resistance state and data 1 (or 0) is written in the selected memory cell. Conversely, when the resistance of the resistance change layer 124 of the selected memory cell is less than the reference resistance, it may be determined that the selected memory cell is in a low resistance state, and data 0 (or 1) is written in the selected memory cell.

When the oxygen vacancy filament 715f is formed in the resistance change layer 124 of the selected memory cell and the resistance of the resistance change layer 124 is less than the reference resistance, the selected memory cell may be said to be in a set state. The set state of the resistance change layer 124 may be maintained even after the write voltage V_{program} is removed. For example, data written in the selected memory cell does not disappear even if the write voltage V_{program} is removed. Accordingly, the selected memory cell may be referred to as a nonvolatile memory cell. Because the resistance state of the resistance change layer 124 may correspond to data 1 or 0 being recorded, the resistance change layer 124 may be expressed as a data layer, a data recording layer, a data recording material layer, or a recording material layer.

FIG. 12 shows a data read operation. A read operation may be expressed as a readout operation.

Referring to FIG. 12, a memory cell on the left is an unselected memory cell, and a voltage Von for channel-on is applied to the gate electrode 140, and a memory cell on the right is a selected memory cell, and a voltage Voff for channel-off is applied to the gate electrode 140. For a read operation, a read voltage Vread that does not change a resistance state of the resistance change layer 124 of the selected memory cell, that is, that does not cut the oxygen vacancy filament 715f is applied to both ends of the channel 132.

A current 11C1 according to the application of the read voltage V_{read} does not flow to the channel 132 in the right memory cell in which the channel is off, but flows through the resistance change layer 124, and the resistance state of the corresponding memory cell may be read by measuring the current 11C1. For example, bit data written in the selected memory cell may be read.

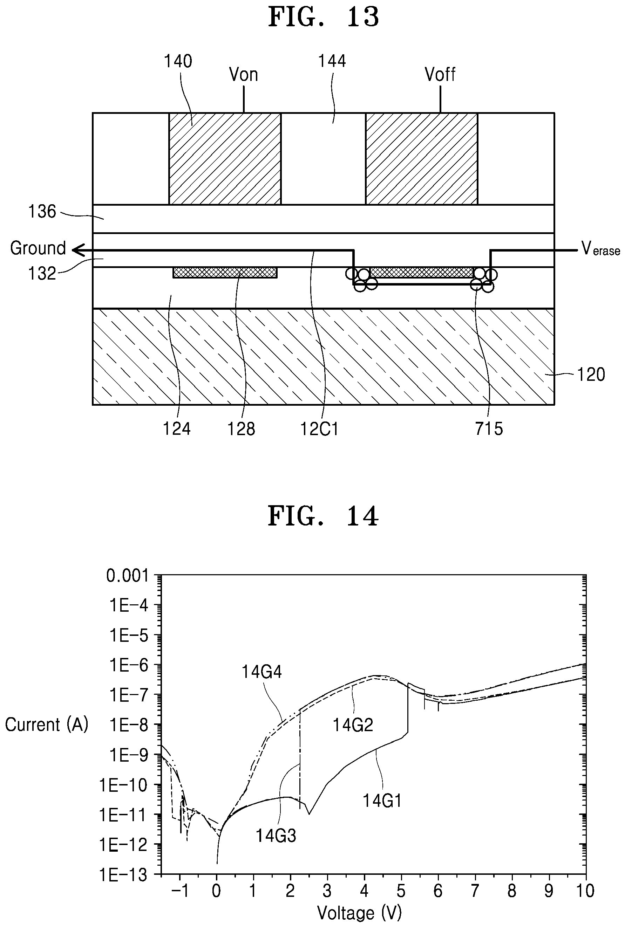

FIG. 13 shows a data erase (delete) operation.

Referring to FIG. 13, in order to erase the information (data) of the right memory cell recorded by the write operation of FIG. 11, an erase voltage Vₑᵣₐₛₑ is applied to both ends of the channel 132 so that a current 12C1 flows in a direction opposite to that in the write operation. A voltage Von for channel-on is applied to the gate electrode 140 of the unselected memory cell on the left, and a voltage Voff for channel-off is applied to the gate electrode 140 of the selected memory cell on the right. In the right memory cell in which the channel is turned off, the current 12C1 does not flow through the channel 132, but flows through the resistance change layer 124, and flows in a direction opposite to that when data is written. Accordingly, the oxygen vacancy filament 715f formed in the writing operation of FIG. 11 is cut off. As a result, due to the application of the erase voltage Vₑᵣₐₛₑ, the resistance change layer 124 of the selected memory cell is in a reset state and is restored to a state prior to writing information. In this regard, the erase voltage Vₑᵣₐₛₑ may be referred to as a reset voltage.

The second memory device 300 is a case in which the island structure 128 in the first memory device 100 is replaced with a plurality of dots 228, and the formation position and a material of the plurality of dots 228 are equal to the island structure 124. In this regard, the operation method of the first memory device 100 illustrated in FIGS. 11 to 13 may also be applied to the operation of the second memory device 300 and may also be equally applied to the operation of a cell string using the second memory device 300 as a unit memory cell.

As described in the operation method with reference to FIGS. 11 to 13, when the island structure 128 exists between the channel 132 and the resistance change layer 124, a high resistance state and a low resistance state of the first memory device 100 may be more clearly distinguished. For example, a set state (low resistance state) may be completely formed while a write voltage (or set voltage) is applied to the first memory device 100, and due to the island structure 128, when an erase voltage (or reset voltage) is applied to the first memory device 100, oxygen vacancies are removed from a surface of the island structure 128 and an oxygen vacancy filament is completely cut off, and accordingly, a reset state (high resistance state) may also be completely formed.

Accordingly, by using the illustrated first or second memory devices 100 and 300 described above as a unit memory cell of a resistive VNAND, in the resistive VNAND of the related art, it may be possible to prevent or reduce the likelihood of and/or the impact from the degradation of the reset efficiency by phenomenon occurring wherein the oxygen vacancy filament is not completely cut off when the reset voltage is applied to a memory device. For example, in the case of a resistive VNAND using the illustrated first or second memory devices 100 and 300 as a unit memory cell, reset efficiency may be improved. As the reset efficiency is improved, the recorded data may be more clearly distinguished and read out, and thus the reliability of the resistive VNAND operation may be increased. Alternatively or additionally, in the case of the first and second memory devices 100 and 300, the oxygen vacancy filament is more likely to completely cut off in a reset state and a current flow is blocked or reduced, and thus, it may be possible to prevent or reduce the degradation of a resistance change layer, which is caused by the fact that the oxygen vacancy filament is not completely cut off in the resistive VNAND of related art. This suggests that the durability of the first and second memory devices 100 and 300 may be increased due to the island structure 124 and the plurality of dots 228 provided in the illustrated first and second memory devices 100 and 300, and alternatively or additionally suggests that the durability of a resistive VNAND that includes the first or second memory devices 100 and 300 as unit memory cells may be improved.

FIG. 14 is a graph showing a current-voltage relationship according to the operation of the first memory device 100 calculated by using technology computer aided design (TCAD) and/or with simulation software such as but not limited to SPICE simulation.

In FIG. 14, a first graph 14G1 shows a first set operation for the first memory device 100, and a second graph 14G2 shows a first reset operation for the first memory device 100 in a set state according to the first set operation, a third graph 14G3 shows a second set operation for the first memory device 100 that is changed to a reset state according to the first reset operation, and a fourth graph 14G4 shows a second reset operation for the first memory device 100 that is re-changed to a set state according to the second set operation. The set operation may denote an operation of applying a set voltage or a write voltage, and the reset operation may denote an operation of applying a reset voltage or an erase voltage.

Referring to the first to fourth graphs 14G1 to 14G4, according to the repetition of the set operation and the reset operation, the state of the first memory device 100 changes from a high resistance state (low current state) to a low resistance state (high current state), and from a low resistance state to a high resistance state, and the two states are clearly distinguished at a given voltage. This result suggests that an oxygen vacancy filament formed along a surface of the island structure 128 in the set operation is completely cut off in the reset operation.

Because the plurality of dots 228 of the second memory device 300 have the same arrangement position or role as the island structure 128 of the first memory device 100, the result of FIG. 14 may be equally applied to the second memory device 300. Alternatively or additionally, because the configuration of the unit memory cell of the resistive VNAND presented as an example is the same or substantially the same as that of the first memory device 100 or the second memory device 300, the result of FIG. 14 may also suggest a current-voltage relationship according to the operation of the resistive VNAND illustrated in FIGS. 9 and 10.

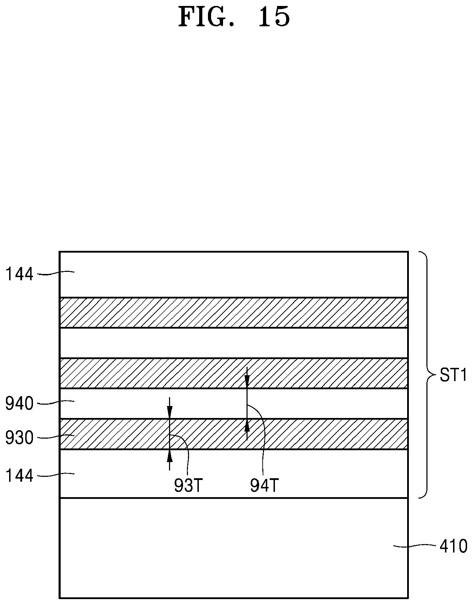

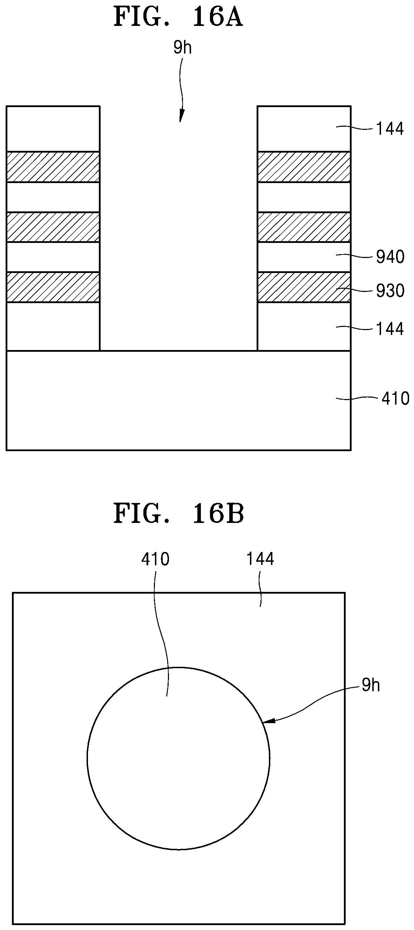

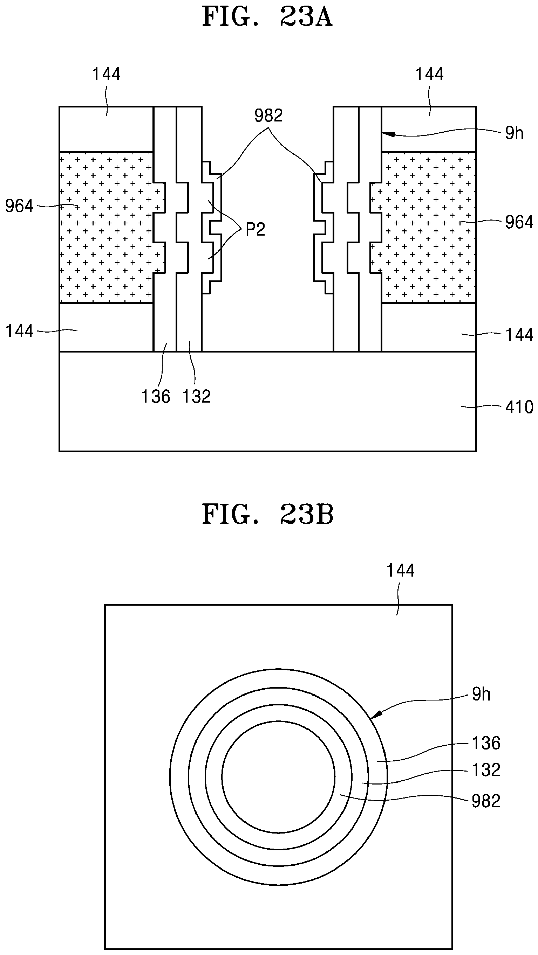

Next, a method of manufacturing a memory device including a vertical resistance change layer according to some example embodiments will be described with reference to FIGS. 15 to 25. FIGS. 16A and 23A are cross-sectional views, and FIGS. 16B and 23B are plan views of FIGS. 16A and 23B.

The manufacturing method is for one unit memory cell (MC) included in one cell string (CS) of a resistive VNAND. Because the resistive VNAND includes a plurality of identical cell strings CS, the illustrated manufacturing method may be applied or extended to a manufacturing method of the resistive VNAND. Like reference numerals as those mentioned in the previous structure description denote the same members.

Referring to FIG. 15, two insulating layers 144 vertically spaced apart from each other are formed on a substrate 410, and a plurality of first sacrificial layers 930 and a plurality of second sacrificial layers 940 are sequentially, repeatedly and vertically stacked between the insulating layers 144, for example with a process such as but not limited to an atomic layer deposition (ALD) process. The second sacrificial layer 940 is formed between the first sacrificial layers 930. For example, the insulating layer 144, the first sacrificial layer 930, and the second sacrificial layer 940 are alternately and repeatedly stacked on one surface (e.g., X-Z plane) of the substrate 410 in a direction perpendicular to the one surface of the substrate 410, and the insulating layer 144 is formed again on top. In this way, when the plurality of first and second sacrificial layers 930 and 940 are formed between the insulating layers 144, the first sacrificial layer 930 is formed to directly contact the one surface of the lower insulating layer 144, and the first sacrificial layer 930 is formed directly under the upper insulating layer 144 so that a lower surface of the upper insulating layer 144 is in direct contact with the first sacrificial layer 930.

In FIG. 15, although it is depicted that three first sacrificial layers 930 and two second sacrificial layers 940 are formed between the insulating layers 144, the number of first sacrificial layers 930 and the number of second sacrificial layers 940 formed between the insulating layers 144 are not limited to three or two.

In a subsequent process, a gate electrode is formed in the place of the first and second sacrificial layers 930 and 940, and the second sacrificial layer 940 may be formed in consideration of the formation position and shape of the island structure or the formation position and shape of the plurality of dots.

Therefore, the number and/or thickness of the first and second sacrificial layers 930 and 940 may be determined in consideration, such as an allowable vertical thickness range of the gate electrode, a vertical length of the island structure, or the number of dots to be formed in the vertical direction in the subsequent process.

In some examples, the substrate 410 may include a silicon substrate, for example, a silicon substrate doped with a predetermined impurity. For example, the substrate 410 may include a p-type silicon substrate, but is not limited thereto.

The insulating layer 144 may be or may include an insulating material layer having a first etch selectivity with respect to etching.

The first sacrificial layer 930 may be or may include an insulating material layer having a second etch selectivity greater than the first etch selectivity with respect to the etching. The second sacrificial layer 940 may be an insulating material layer having a third etch selectivity with respect to the above etching or may include such an insulating material layer. In some examples, the third etch selectivity may be greater than the first and second etch selectivities. Therefore, when the etching is performed, the second sacrificial layer 940 may be etched first before the insulating layer 144 or the first sacrificial layer 930. The etch selectivities of the insulating layer 144, the first sacrificial layer 930, and the second sacrificial layer 940 are all different from each other. Accordingly, one or more of a thickness, width, or length in vertical and horizontal directions of the insulating layer 144, the first sacrificial layer 930, and the second sacrificial layer 940 may be determined in consideration of each etch selectivity. Alternatively or additionally, the first to third etch selectivities may have such a difference that a material layer having a small etch selectivity is hardly etched while a material layer having a high etch selectivity is etched. Due to the etch selectivity, the insulating layer 144 and the first sacrificial layer 930 may hardly be etched while the second sacrificial layer 940 is completely etched, and the insulating layer 144 may be hardly etched while the first sacrificial layer 930 is etched.

In some examples, the first sacrificial layer 930 may include a different material from the insulating layer 144 and the second sacrificial layer 940 and may be a nitride layer or include a nitride layer. For example, the first sacrificial layer 930 may be a silicon nitride layer or include a silicon nitride layer, but may not be limited thereto. In some examples, the second sacrificial layer 940 may include a material different from that of the insulating layer 144 and may be an oxide layer or include an oxide layer. For example, the second sacrificial layer 940 may be a silicon oxide layer or include a silicon oxide layer, but is not limited thereto.

In some examples, the thickness of the first sacrificial layer 930 may be in a range from 1 nm to 100 nm, and the thickness of the second sacrificial layer 940 may be in a range from 1 nm to 100 nm.

To form the insulating layer 144 and the first and second sacrificial layers 930 and 940, a deposition method, such as one or more of an atomic layer deposition (ALD) method, a metal organic atomic layer deposition (MOALD) method, a chemical vapor deposition (CVD) method, a metal organic chemical vapor deposition (MOCVD) method, a physical vapor deposition (PVD) method, etc. may be used. The methods include placing the substrate 410 in a chamber, heating the chamber to a predetermined temperature, and supplying a source, and process conditions, such as temperature and time, may be adjusted according to a desired thickness.

Next, as shown in FIGS. 16A and 16B, a vertical through hole 9h through which the substrate 410 is exposed is formed in the stack structure ST1 formed on the one surface of the substrate 410 of FIG. 15. The vertical through hole 9h is a hole for coating a gate insulating material, a channel material, a material for forming an island structure, a resistance change material, and the like. A photolithography and an etching process may be used to form the through hole 9h.

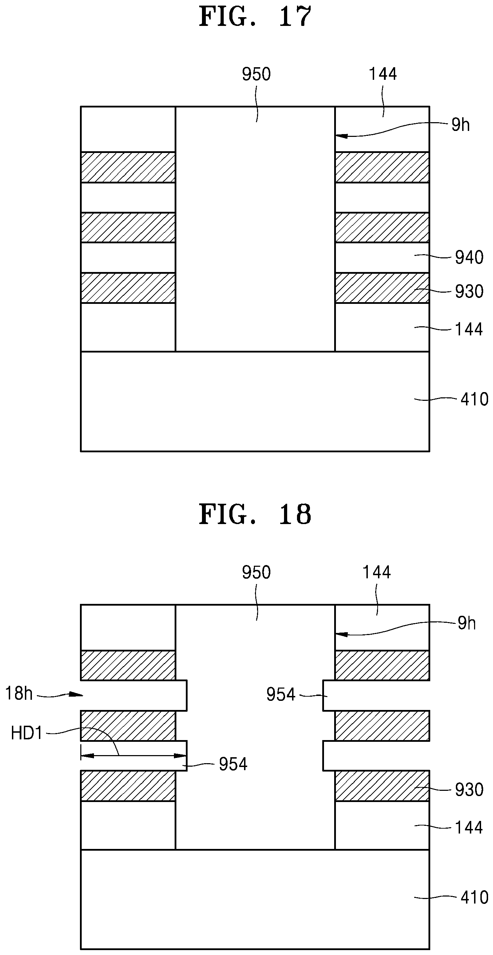

Next, as shown in FIG. 17, the through hole 9h is filled with a third sacrificial layer 950. The third sacrificial layer 950 may provide a region for forming an island structure (e.g., 128 in FIG. 1 or 228 in FIG. 3) in a subsequent process. In some examples, the third sacrificial layer 950 may include the same material as the second sacrificial layer 940.

After the third sacrificial layer 950 is formed, the second sacrificial layer 940 is removed from FIG. 17 to form a first gate hole 18h as shown in FIG. 18. The first gate hole 18h may be formed in a horizontal direction (e.g., an X-axis direction) parallel to the one surface (X-Z plane) of the substrate 410. The first gate hole 18h is formed longer than a length of the second sacrificial layer 940 in the horizontal direction. For example, a horizontal depth HD1 of the first gate hole 18h is greater than a horizontal length of the second sacrificial layer 940. The first gate hole 18h may be formed by further performing the etching process for a first time after the second sacrificial layer 940 is completely removed in the etching process of removing the second sacrificial layer 940. In other words, if a time taken to completely etch the second sacrificial layer 940 is t, the first gate hole 18h may be formed by performing the etching process of the second sacrificial layer 940 for a time of t+Δt, where Δt is much less than t.

Looking more closely at the etching process of the second sacrificial layer 940, after the second sacrificial layer 940 is completely removed through the etching process of the second sacrificial layer 940, a side surface of the third sacrificial layer 950 is exposed. The third sacrificial layer 950 includes the same material as the second sacrificial layer 940, and the exposed side surface of the third sacrificial layer 950 may further be etched for Δt time. As a result, a horizontally concave portion or recess, e.g., a shallow trench 954 is formed on the exposed side surface of the third sacrificial layer 950. The first gate hole 18h includes the trench 954 as well.

Because the two second sacrificial layers 940 are formed between the insulating layers 144, two first gate holes 18h are formed between the insulating layers 144, and also two trenches 954 are formed on the side of the third sacrificial layer 950, but the number of the second sacrificial layers 940 formed between the insulating layers 144 may be one or three or more. Therefore, the number of first gate holes 18h and the number of trenches 954 formed on the side surfaces of the third sacrificial layer 950 (the number of concave portions) may be one or three or more.

In the process of etching the second sacrificial layer 940, an upper surface of the third sacrificial layer 950 may be protected by a protective member such as a mask so as not to be exposed to the etching process.

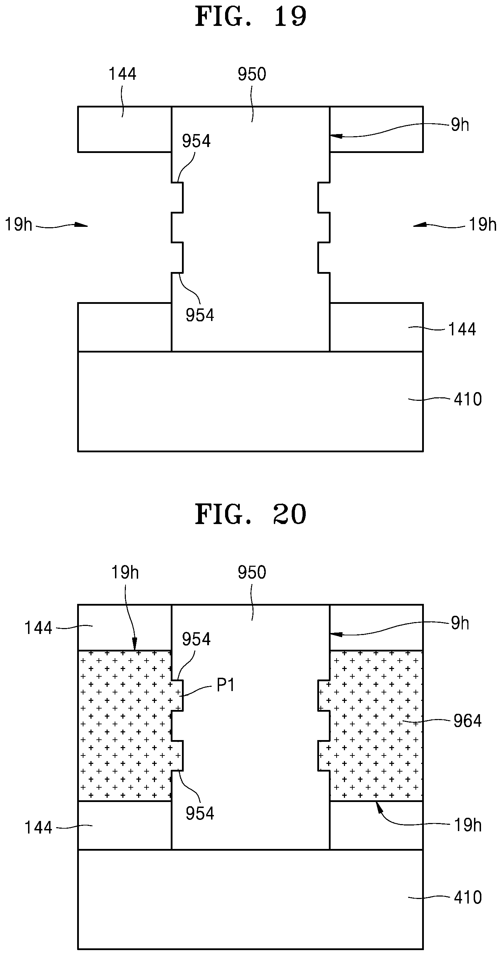

After the first gate hole 18h is formed, even the first sacrificial layer 930 between the insulating layers 144 is removed by etching. As a result, as shown in FIG. 19, a second gate hole 19h is formed between the insulating layers 144. The second gate hole 19h is a region including a region where the first sacrificial layer 930 was located, the first gate hole 18h, and the trench 954 formed on a side surface of the third sacrificial layer 950.

Next, as shown in FIG. 20, the second gate hole 19h is filled with an electrode material. The second gate hole 19h may be completely filled with the electrode material. In this way, an electrode material layer 964 is formed between the insulating layers 144. The electrode material layer 964 completely fills the trench 954 formed on the side surface of the third sacrificial layer 950. Accordingly, the electrode material layer 964 has a structure in which a portion thereof protrudes in a horizontal direction. A portion P1 of the electrode material layer 964 filling the trench 954 may be expressed as a protruding portion P1 of the electrode material layer 964. The protruding portion P1 may be regarded as a first pattern of the electrode material layer 964, and the trench 954 of the third sacrificial layer 950 corresponding to the protruding portion P1 may be regarded as a second pattern formed in the third sacrificial layer 950.

The electrode material layer 964 may be or may include or be included in a gate electrode 140.

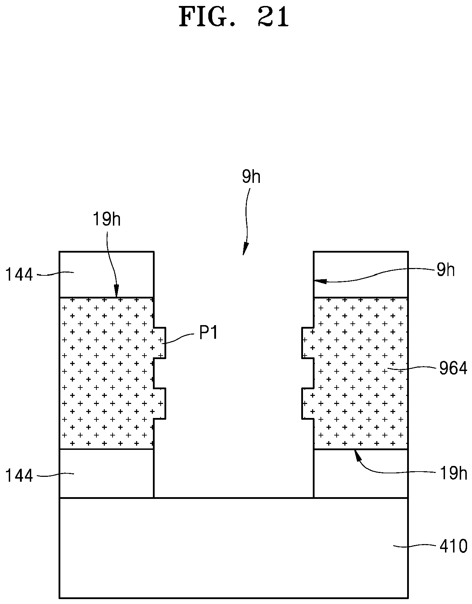

Next, as shown in FIGS. 20 and 21, the third sacrificial layer 950 is etched and removed from the vertical through hole 9h. The third sacrificial layer 950 may be completely removed.

After the electrode material layer 964 is formed, while the third sacrificial layer 950 is removed, and as shown in FIG. 21, an inner surface of the electrode material layer 964 and an inner surface of the insulating layer 144 are exposed. Also, the protruding portion P1 of the electrode material layer 964 becomes a protruding structure to the vertical through hole 9h. The protruding portions P1 are vertically spaced apart from each other. Because the number of the protruding portions P1 is the same as the number of second sacrificial layers 940 formed between the insulating layers 144, the number of the protruding portions P1 may be one or two or more depending on the number of second sacrificial layers 940.

In some examples, when only one protruding portion P1 of the electrode material layer 964 is formed between the insulating layers 144, a length of the protruding portion P1 in the vertical direction may be greater than that shown in FIG. 21.

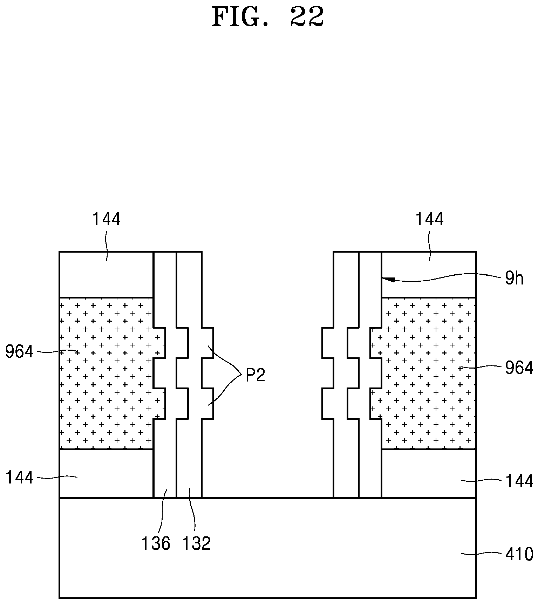

Next, as shown in FIG. 22, a gate insulating layer 136 and a channel 132 are sequentially formed on an inner surface of the vertical through hole 9h in an inward direction. As shown in FIGS. 16A and 16B, because the through hole 9h is cylindrical, the gate insulating layer 136 and the channel 132 may be formed to be concentric circles. The shape of the protruding portion P1 of the electrode material layer 964 may be sequentially transferred to the gate insulating layer 136 and the channel 132. Accordingly, a portion of the channel 132 corresponding to the protruding portion P1 of the electrode material layer 964 is also convex to an inside of the through hole 9h. For example, a protruding portion P2 protruding to the inside of the through hole 9h is also formed on an inner surface of the channel 132.

Next, as shown in FIGS. 23A and 23B, a material layer 982 covering the protruding portion P2 on the inner surface of the channel 132 is formed. The material layer 982 may not be formed on the entire inner surface of the channel 132 but only on the protruding portion P2. In some examples, the material layer 982 may be formed using a method of selectively forming only on the protruding portion P2. Accordingly, the material layer 982 belongs only to a corresponding memory cell and does not belong to an adjacent memory cell. The material layer 982 may correspond to the island structure 128 of the memory devices according to example embodiments.

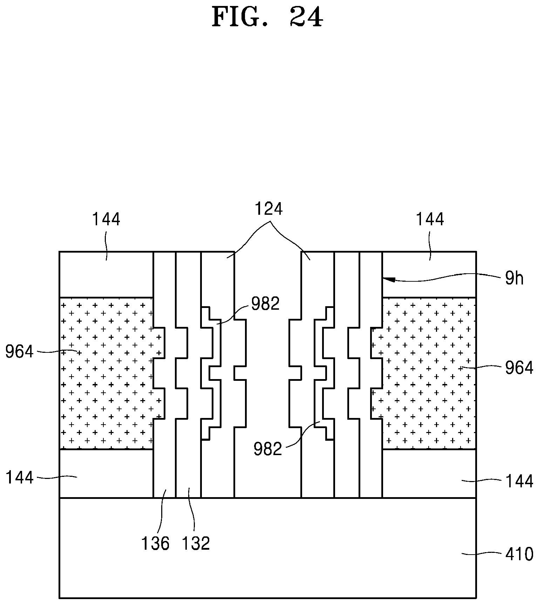

Next, as shown in FIG. 24, a resistance change layer 124 covering the material layer 982 is formed on the inner surface of the channel 132. The resistance change layer 124 may be formed to completely cover the inner surface of the channel 132 and the entire material layer 982, and a lower end of the resistance change layer 124 may be formed to contact the substrate 410.

To form the material layers 136, 132, 982, and 124, a deposition method such as one or more of an ALD method, a MOALD method, a CVD method, a MOCVD method, a PVD method, or a plasma enhanced ALD (PEALD) method may be used. These methods include a process of forming the electrode material layer 964, placing a resultant product from which the third sacrificial layer 950 is removed, that is, the resultant product shown in FIG. 21 in a chamber, and supplying a source while heating a chamber to a predetermined temperature, and process conditions of temperature and time are adjusted according to the desired thickness for each layer.

Meanwhile, as shown in FIG. 22, after sequentially forming the gate insulating layer 136 and a channel 132 on the inner surface of the vertical through hole 9h, before forming the material layer 982 and a resistance change layer 124, a process of removing an insulating material and a channel material deposited on a bottom surface exposed through the through hole 9h, that is, an upper surface of the substrate 410 may be performed.

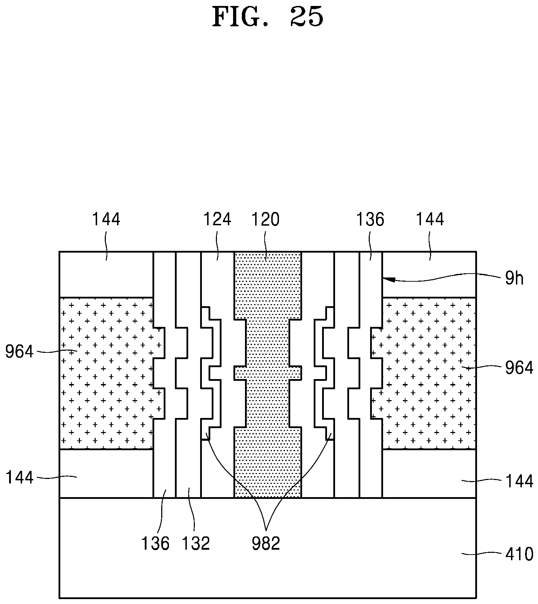

After forming the resistance change layer 124, as shown in FIG. 25, the base 120 is formed in the remaining space inside the through hole 9h. The remaining space inside the through hole 9h may be completely filled with the base 120. The base 120 may also be expressed as a buried material.

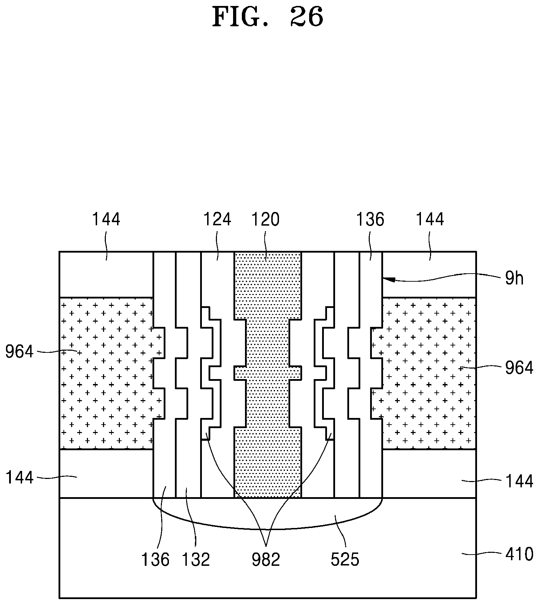

Next, as shown in FIG. 26, a common source region 525 is formed in the substrate 410. This process is a process of forming a highly concentration region by injecting a dopant into a predetermined region on the substrate 410, and the common source region 525 may be formed to contact lower ends of the channel 132 and the resistance change layer 124. The common source region 525 may be extended to be shared by two horizontally adjacent memory cells. The common source region 525 may be a common source region of two adjacent cell strings.

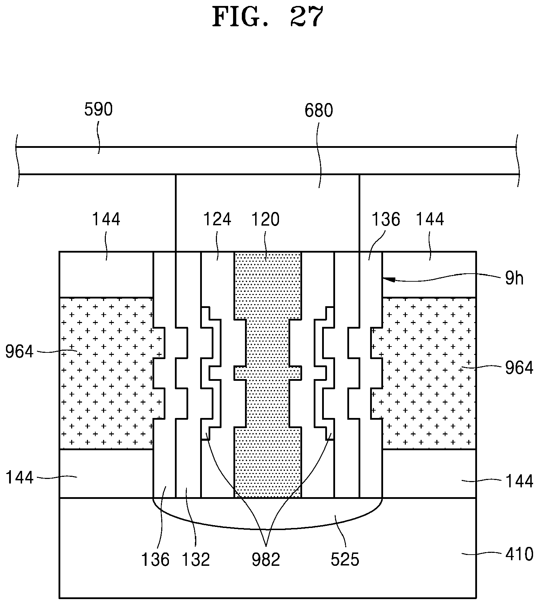

Next, as shown in FIG. 27, a drain region 680 connected to the top of the channel 132 and the resistance change layer 124 is formed, and a bit line 590 connected to the drain region 680 is formed. The upper ends of the channel 132 and the resistance change layer 124 are opposite to the lower ends of the channel 132 and the resistance change layer 124 in contact with the common source region 525.

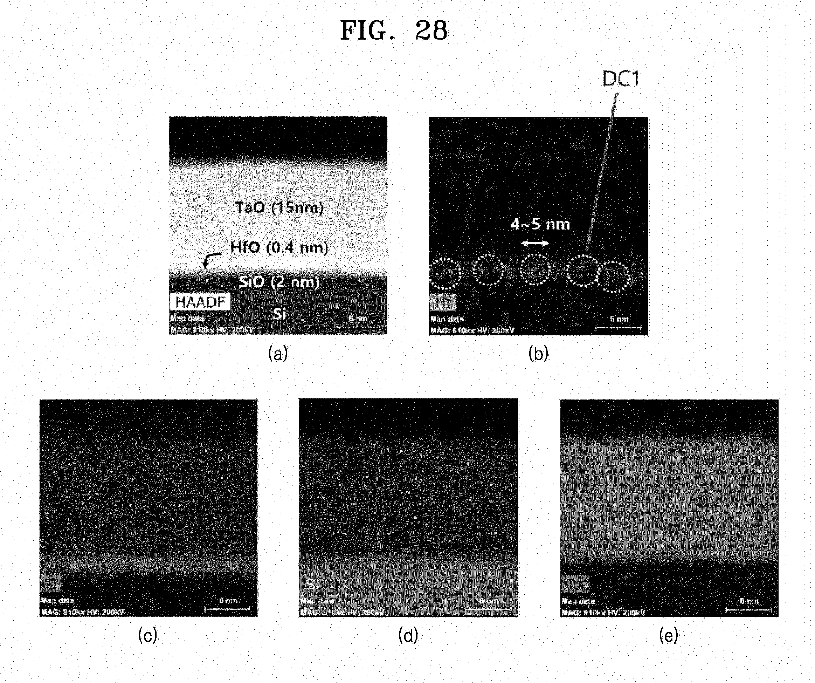

FIG. 28 is a scanning electron microscope (SEM) photograph showing the results of an experiment conducted to confirm that an island corresponding to an island structure 128 or a plurality of dots 228 is formed in a memory device according to some example embodiments.

In the experiment to obtain the experimental results of FIG. 28, after sequentially forming a hafnium oxide film and a tantalum oxide film on a silicon substrate, it was examined whether the hafnium oxide film is formed in an island shape. In the experiment, the hafnium oxide film was formed to a thickness of about 0.4 nm, and the tantalum oxide film formed as a resistance change layer was formed to a thickness of about 15 nm.

Part (a) of FIG. 28 shows a layer structure in which a hafnium oxide film and a tantalum oxide film are sequentially formed on a silicon substrate. In (a), SiO represents a natural oxide film. Part (b) of FIG. 28 is a distribution photograph of hafnium showing where hafnium is distributed in the layer structure shown in (a). Part (c) of FIG. 28 is a distribution photograph of oxygen (O) in the layer structure shown in (a). Part (d) of FIG. 28 is a distribution photograph of silicon (Si) in the layer structure shown in (a). Part (e) of FIG. 28 is a distribution photograph of tantalum (Ta) in the layer structure shown in (a).

In (b) of FIG. 28, the dotted line DC1 represents a hafnium island having a length of about 4 to 5 nm. That is, (b) of FIG. 28 shows a case when a hafnium oxide film and a tantalum oxide film (corresponding to a resistance change layer) are sequentially formed on a silicon substrate (corresponding to a silicon channel), and shows that hafnium islands may be formed between the silicon substrate and the tantalum oxide film according to the thickness of the hafnium oxide film.

This result suggests that an island structure 128 or a plurality of dots 228 may actually be formed between the channel 132 and the resistance change layer 124 of the memory devices 100, 300, 400, and 900 described above.

Each of or any of the memory devices 100, 300, 400, and 900 according to the disclosure may be employed in memory systems of various electronic apparatuses. Each of the memory devices 100, 30, 400, and 900 may be implemented as a memory block in the form of a chip and may be used as a neuromorphic computing platform or used to construct a neural network.

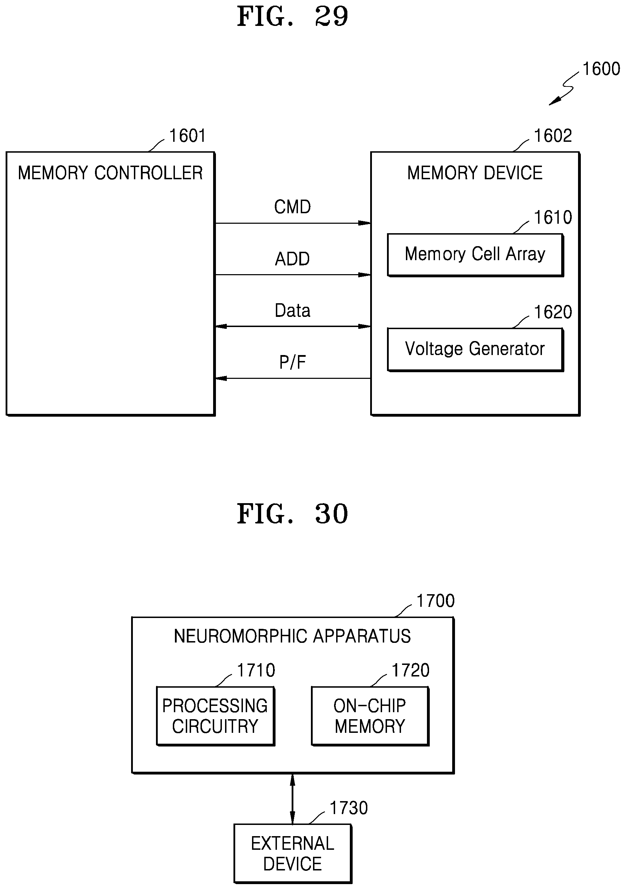

FIG. 29 is a block diagram of a memory system 1600 according to some example embodiments.

Referring to FIG. 29, the memory system 1600 may include a memory controller 1601 and a memory device 1602. The memory controller 1601 performs a control operation for the memory device 1602. For example, the memory controller 1601 may provide an address ADD to the memory device 1602 and a command CMD for performing programming (or writing) and reading and/or erasing operations on the memory device 1602. Also, data for programming operations and read data may be transferred between the memory controller 1601 and the memory device 1602.

The memory device 1602 may include a memory cell array 1610 and a voltage generator 1620. The memory cell array 1610 may include a plurality of memory cells arranged in a region where a plurality of word lines and a plurality of bit lines cross each other. The memory cell array 1610 may include one of the memory devices 100, 30, 400, and 900 illustrated in FIGS. 1 to 10.

The memory controller 1601 may include a processing circuit, such as hardware including a logic circuit, a combination of hardware/software, such as processor-execute software, or a combination thereof. For example, more specifically, the processing circuits may include or be included in one or more of a central processing unit (CPU), an arithmetic logic unit (ALU), a digital signal processor, a microcomputer, a field programmable gate array (FPGA), a system-on-chip (SoC), a programmable logic unit, a microprocessor, an application-specific integrated circuit (ASIC), etc., but is not limited thereto. The memory controller 1601 may operate in response to a request from a host (not shown). The memory controller 1601 may access the memory device 1602 and control the control operations discussed above (e.g., write/read operations), and therefore, the memory controller 1601 may be configured to a special purpose controller. The memory controller 1601 may generate an address ADD and a command CMD for performing a program/read/erase operation on the memory cell array 1610. In addition, in response to a command from the memory controller 1601, the voltage generator 1620 (e.g., a power circuit) may generate a voltage control signal for controlling a voltage level of a word line for programming or reading data to the memory cell array 1610.

Also, the memory controller 1601 may perform a determination operation on data read from the non-volatile memory device 1602. For example, from the data read from memory cells, the number of on-memory cells and/or the number of off-memory cells may be determined. The memory device 1602 may provide a pass/fail signal (P/F) to the memory controller 1601 according to a result of reading the read data. The memory controller 1601 may control write and read operations of the memory cell array 1610 by referring to the pass/fail signal (P/F).

FIG. 30 is a block diagram showing a neuromorphic apparatus 1700 and an external device 1730 connected thereto according to some example embodiments.

Referring to FIG. 30, the neuromorphic apparatus 1700 may include a processing circuitry 1710 and/or an on-chip memory 1720. The neuromorphic apparatus 1700 may include one of the memory devices 100, 30, 400, and 900 illustrated in FIGS. 1 to 10.

In some example embodiments, the processing circuitry 1710 may be configured to control functions for driving a neuromorphic apparatus 1700. For example, the processing circuitry 1710 may be configured to control the neuromorphic apparatus 1700 by executing a program stored in the memory 1720. In some embodiments, processing circuitry 1710 may include hardware such as logic circuitry, a combination of hardware/software such as a processor executing software, or a combination thereof. For example, the processor may include one or more of a central processing unit (CPU), a graphics processing unit (GPU), an application processor (AP) included in the neuromorphic apparatus 1700, an arithmetic logic unit (ALU), a digital signal processor, a microcomputer, a field programmable gate array (FPGA), a system-on-chip (SoC), a programmable logic unit, a microprocessor, an application-specific integrated circuit (ASIC), etc., but is not limited thereto. In some embodiments, processing circuitry 1710 is configured to read/write various data to an external device 1730 and/or to execute the neuromorphic apparatus 1700 by using the read/written data. In some example embodiments, the external device 1730 may include an external memory and/or sensor array having an image sensor (e.g., a CMOS image sensor circuit).

In some example embodiments, the neuromorphic apparatus 1700 of FIG. 30 may be applied to a machine learning system. The machine learning systems may use a variety of artificial neural network organization and processing models, such as one or more of a convolutional neural network (CNN), a deconvolutional neural network, a recurrent neural network (RNN) optionally including a long short-term memory (LSTM) unit and/or a gated recurrent unit (GRU), stacked neural network (SNN), state-space dynamic neural network (SSNN), deep faith network (DBN), generative adversarial network (GAN), and/or restricted Boltzmann machine (RBM).

Alternatively or additionally, the machine learning systems may include other types of machine learning models, for example, a combination including ensembles such as linear and/or logistic regression, statistical clustering, Bayesian classification, decision trees, dimensionality reduction such as principal component analysis, expert systems, and/or random forests. Such a machine learning model may be used to provide various services and/or applications, and, for example, an image classification service, a user authentication service based on biometric information or biometric data, an advanced driver assistance system (ADAS) service, a voice assistant service, an automatic speech recognition (ASR) service, or the like may be executed by the electronic apparatus.

In a memory device according to some example embodiments, an independent thin material layer, for example, an island structure, is provided between a resistance change layer (variable resistance material layer) used as a recording material layer and a channel. Due to the existence of the island structure, an oxygen vacancy filament may be formed around the island structure during a set operation of the memory device, and during a reset operation, the oxygen vacancy filament may be more easily and completely cut off. These results may be maintained even in repeated operations. Because the island structure is provided as described above, the reset efficiency of the memory device may be increased, and thus, a high resistance state and a low resistance state of the memory device may be more clearly distinguished. This suggests that recorded data may be clearly distinguished. Therefore, when a memory device according to the disclosure is used, operation reliability of the memory device may be increased. Alternatively or additionally, because the oxygen vacancy filament is completely cut off in the reset state, it may be possible to prevent or reduce the deterioration of a recording material layer, which may occur when the oxygen vacancy filament is incompletely cut off. Accordingly, durability of the recording material layer may be increased, and furthermore, durability of the memory device may be increased.

Any or all of the elements described with reference to FIGS. 29 and 30 may communicate with any or all other elements described with reference to FIG. 29 and 30; for example, any element may engage in one-way and/or two-way and/or broadcast communication with any or all other elements in FIG. 29 and 30, to transfer and/or exchange information such as but not limited to data and/or commands, in a serial and/or parallel manner, via a wireless and/or a wired bus (not illustrated). Information transferred and/or exchanged may be encoded in an analog and/or a digital manner; example embodiments are not limited thereto.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that various example embodiments described herein should be considered in a descriptive sense only and not for purposes of limitation. Descriptions of features or aspects within each example embodiment should typically be considered as available for other similar features or aspects in other example embodiments, and example embodiments are not necessarily mutually exclusive with one another. While one or more embodiments have been described with reference to the figures, it will be understood by those of ordinary skill in the art that various changes in form and details may be made therein without departing from the scope as defined by the following claims.

## Claims

1. A memory device comprising:
a gate electrode;
a resistance change layer;
a channel between the gate electrode and the resistance change layer;
an island structure between the resistance change layer and the channel and in contact with the resistance change layer and the channel; and
a gate insulating layer between the gate electrode and the channel.

2. The memory device of claim 1, wherein the island structure includes nitride and/or oxide.

3. The memory device of claim 2, wherein the island structure includes SiN and/or GaN.

4. The memory device of claim 2, wherein the island structure includes an oxide having a greater absolute value of oxide formation energy than a formation energy of the resistance change layer, and optionally wherein the oxide includes a metal oxide, and the metal oxide includes one or more of Rb, Ti, Ba, Zr, Ca, Hf, Sr, Sc, Mg, Al, Si, Be, Nb, Ni, Ta, W, V, La, Gd, Cu, Mo, Cr, or Mn as a metallic element.

5. The memory device of any preceding claim, wherein
the gate electrode, the channel, and the resistance change layer are included in a memory cell, and the memory device further comprises:
a substrate and a plurality of the memory cells stacked in a direction perpendicular to a surface of the substrate.

6. The memory device of claim 5, wherein the channel and the resistance change layer of each of the plurality of the memory cells are connected to each other in a vertical direction, and optionally wherein the gate electrodes of each of the plurality of the memory cells are electrically isolated from each other.

7. The memory device of claim 5 or 6, wherein at least one of the plurality of memory cells includes a plurality of island structures not connected to each other.

8. The memory device of any preceding claim, wherein a cross-sectional area of the island structure is less than a cross-sectional area of the gate electrode.

9. The memory device of any preceding claim, wherein the island structure is surrounded by the channel and the resistance change layer.

10. The memory device of any preceding claim, wherein the island structure includes an archipelago of islands.

11. The memory device of any preceding claim, wherein
the resistance change layer, the island structure, the channel, the gate insulating layer, and the gate electrode correspond to a first gate stack,
the memory device includes a plurality of the first gate stacks,
the plurality of first gate stacks share the resistance change layer, the channel, and the gate insulating layer, and
an insulating layer is between the gate electrodes in the plurality of the first gate stacks, and optionally further comprising:
a substrate,
wherein the plurality of first gate stacks are on the substrate, and
the plurality of first gate stacks are sequentially stacked in a direction perpendicular to the substrate to form a first cell string.

12. An electronic apparatus comprising: a memory device according to any preceding claim.

13. A method of manufacturing a memory device, the method comprising:
forming a first pattern on an inner surface of a gate electrode; and
forming a stack covering the first pattern on the inner surface of the gate electrode and including an island structure,
wherein the island structure is formed at a position corresponding to the first pattern, and
the island structure includes either or both of oxide and nitride.

14. The method of claim 13, wherein the forming of the stack includes sequentially forming, on the inner surface of the gate electrode, a gate insulating layer, a channel, the island structure, a resistance change layer, and a base layer that covers the first pattern.

15. The method of claim 13 or 14, wherein the forming of the first pattern on the inner surface of the gate electrode includes:
defining, in a sacrificial layer, a region where the gate electrode is to be formed in a sacrificial layer;
forming a second pattern opposite to the first pattern of the gate electrode in the defined region of the sacrificial layer;
forming the gate electrode covering the second pattern on the defined region of the sacrificial layer; and
removing the sacrificial layer.
